# EUROPEAN PATENT APPLICATION

(11) **EP 4 651 161 A1**
(43) Date of publication of application: **19.11.2025**
(21) Application number: 24752767.4
(22) Date of filing: 31.01.2024
(51) Int. Cl.: H01F 6/06, H01F 6/04, C30B 30/04

(54) **MAGNETIC CONTROL COIL AND CRYSTAL FABRICATION APPARATUS**

(30) Priority: 06.02.2023 CN 202310069328
(71) Applicant: Biaotangtu (Beijing) Equipment Technology Development Co., Ltd, Beijing 100102 (CN)
(72) Inventor: LI, Zhentan, Beijing 100102 (CN); LI, Guokun, Beijing 100102 (CN); TIAN, Lichao, Beijing 100102 (CN)
(74) Representative: Murgitroyd & Company
(86) International application number: PCT/CN2024/075032
(87) International publication number: WO 2024/164911

(57) **Abstract**

The present application discloses a magnetic control coil, comprising: a coil support structure and N pairs of coil assemblies, wherein the coil assemblies are arranged in a planar manner along the surface of the coil support structure; N is an integer not less than 1. The present application employs a plurality of surface-type coils to replace conventional rectangular cross-section circular, racetrack-shaped, or saddle-shaped coils, which can enhance the generation efficiency of transverse magnetic fields, thereby effectively suppressing the introduction of impurities and the generation of defects during crystal manufacturing processes and improving the efficiency and quality of crystal manufacturing.

## Description

The present application claims priority to Patent Application 202310069328.8 filed with the China National Intellectual Property Administration on February 6, 2023, the entire contents of which are incorporated herein by reference.

### TECHNICAL FIELD

The present application relates to the technical field of crystal manufacturing and particularly relates to a magnetic control coil and crystal manufacturing equipment.

### BACKGROUND

In the field of crystal manufacturing, crystal preparation is typically performed using methods such as the Czochralski method and zone melting method, followed by post-processing such as cutting and polishing of the prepared crystals to obtain components with specific functions. For example, in the monocrystalline silicon pulling manufacturing process, molten crystal raw materials are gradually solidified from liquid phase to solid phase according to specific processes, forming crystals with specific atomic arrangement structures, wherein the crystals may be polycrystals or single crystals. During the crystal pulling growth process, thermal convection effects in the melt frequently cause various defects , such as point defects or the incorporation of impurity elements, to occur at the solid-liquid interface during crystal growth.

Therefore, effectively suppressing the influence of melt thermal convection on crystal growth during the crystal growth process (particularly for large-size crystals) represents an urgent problem requiring resolution in the field of crystal manufacturing.

### SUMMARY

To reduce the influence of thermal convection on crystal quality during the crystal growth process, the present application discloses a magnetic control coil and crystal manufacturing equipment. Based on magnetic control coils arranged in a planar distribution along the surface of the coil support structure, the transverse magnetic field strength can be enhanced, thereby effectively suppressing defect generation and impurity introduction during the crystal manufacturing process and improving crystal manufacturing efficiency and quality.

According to a first aspect of the present application, there is provided a magnetic control coil comprising a coil support structure and N pairs of coil assemblies, wherein the coil assemblies are arranged in a planar manner along the surface of the coil support structure; and N is an integer not less than 1.

In an embodiment, the coil support structure is arranged around a central axis; an i-th pair of coil assemblies among the N pairs of coil assemblies are symmetrically distributed relative to the central axis; and i is an integer not less than 1 and not greater than N.

In an embodiment, the coil support structure is configured to be cylindrical and manufactured from stainless steel or aluminum alloy.

In an embodiment, cylindrical side surface of the coil support structure comprises coil regions and non-coil regions thereon; wherein the coil region is configured to arrange coil assemblies, and the non-coil region is configured as a perforated structure.

In an embodiment, each of the coil assemblies comprises M layers of coils, wherein M is an integer not less than 1; and in the case where M is not less than 2, the (j+1)-th layer coil is positioned above the surface of the j-th layer coil that is distal from the central axis, wherein j is an integer not less than 1 and not greater than M.

In an embodiment, planar shape of each of the coil assemblies, when spread along the surface of the coil support structure, is in the form of concentric rectangle; and the concentric rectangle comprises first direction segments, which are line segments parallel to the direction of the central axis.

In an embodiment, the concentric rectangle comprises second direction segments; the second direction segments are line segments perpendicular to the direction of the central axis.

In an embodiment, transition arcs are disposed between the first direction segments and the second direction segments, wherein the curvature radius of the arcs is not less than a preset threshold.

In an embodiment, the N pairs of coil assemblies are formed by winding a same group of conductive wires; and the same group of conductive wires are formed by multiple conductive wires arranged side by side, twisted, or braided together.

In an embodiment, the coil assemblies are made of superconducting material.

In an embodiment, the magnetic control coil has current leads, which are configured to connect the magnetic control coil with a power supply.

In an embodiment, grooves are provided on the surface of the coil support structure, and the grooves are configured to secure the coil assembly.

In an embodiment, a thermal conductive layer is disposed on the surface of the coil support structure; wherein the thermal conductive layer comprises at least one of the following: a pure copper plate, a pure aluminum plate, or piping through which cryogenic fluid flows.

According to a second aspect of the present application, a crystal manufacturing equipment is provided, comprising a crystal growth furnace and any one of the aforementioned magnetic control coils; wherein the crystal growth furnace is configured with a heating device and a crucible for containing crystal raw materials, and the crucible is positioned within a chamber of the crystal growth furnace; the magnetic control coil is positioned around the crystal growth furnace and symmetrically distributed along the central axis of the crystal growth furnace.

In an embodiment, the crystal manufacturing equipment further comprises: a thermally insulated vacuum chamber, within which the magnetic control coil is arranged.

In an embodiment, the crystal manufacturing equipment further comprises: a refrigeration apparatus, which is configured to reduce the temperature within the thermally insulated vacuum chamber.

In an embodiment, the interior of the thermally insulated vacuum chamber provides a vacuum environment, and the magnetic control coil is suspended within the vacuum environment of the thermally insulated vacuum chamber by means of a suspension rod.

### BRIEF DESCRIPTION OF THE DRAWINGS

Figure 1 shows a schematic diagram of a magnetic control coil structure of the present application;
Figure 2 shows a schematic diagram of a coil assembly structure of the present application;
Figure 3 shows a schematic diagram of a crystal manufacturing equipment structure.

### DETAILED DESCRIPTION

To better understand the technical solutions of the present application, the application scenarios of the magnetic control coil and crystal manufacturing equipment involved in the present application are further described herein. It should be understood that the scenario descriptions herein are merely for a better understanding of the technical solutions of the present application and should not limit the application scenarios of the present application. The magnetic control coil involved in the present application can be applied in the field of monocrystalline silicon manufacturing. During the monocrystalline silicon manufacturing process, crystals grown by the Czochralski method are often highly susceptible to the influence of melt thermal convection. Particularly, with the rapid development of manufacturing technologies for semiconductor microelectronic devices, large-scale integrated circuits, solar panels and other devices, the requirements for the quality and size of monocrystalline silicon are becoming increasingly stringent. During the preparation process of such large-size monocrystalline silicon, the thermal convection of the melt is further enhanced, and the impact on impurity elements (such as oxygen) and melt uniformity is further increased, often leading to degradation of crystal quality and making it difficult to prepare large-size, high-quality monocrystalline silicon crystals.

To better reduce the impact of thermal convection on crystal quality, the magnetic control coil proposed in the present application can effectively solve this problem. Furthermore, the magnetic control coil of the present application have features such as high magnetic field utilization efficiency, concentrated magnetic force, uniform magnetic field, simple installation and maintenance, and low cost.

The present application discloses a magnetic control coil, comprising: a coil support structure and N pairs of coil assemblies, wherein the coil assemblies are arranged in a planar manner along the surface of the coil support structure; and N is an integer not less than 1.

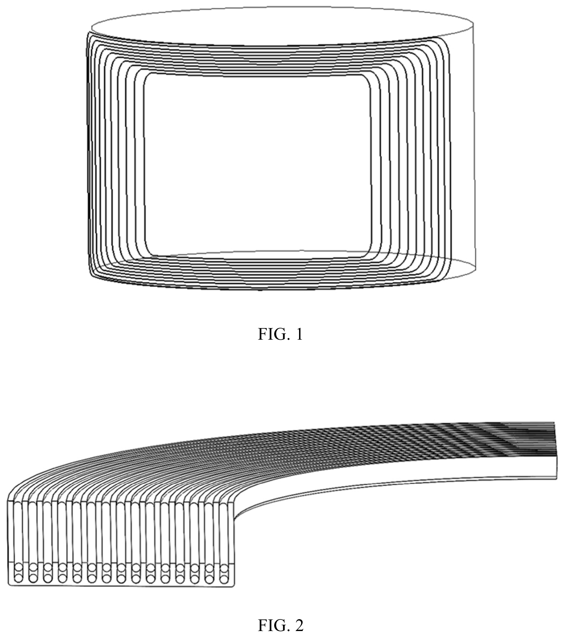

Referring to Figure 1, in the present application, the coil support structure may be a coil support framework configured for fixing the coil assemblies and providing electromagnetic force support. The number of coil assemblies may be configured according to the required magnetic field strength, for example, the quantity of N pairs of coil assemblies may be 1 pair, 2 pairs, or 3 pairs, without limitation thereto.

The coil assembly comprises a plurality of coils wound in a helical configuration, wherein the spacing between each coil and its neighboring coil may be configured according to requirements; for example, the spacing may be 2 mm, 3 mm, 4 mm, or other dimensions, without limitation thereto. The coil winding configuration may comprise helical winding along the surface of the coil support structure from an inner side toward an outer side, or alternatively helical winding from an outer side toward an inner side, without limitation thereto.

In the present application, a plurality of coils are formed by winding a set of conductive wires on the surface of the coil support structure, wherein the plurality of coils are arranged in a two-dimensional planar manner on the surface of the coil support structure. Wherein, the surface of the coil support structure may be either planar or curved, which is not limited herein. The two end wires of a group of conductive wires extend to form the current leads of the plurality of coils. The magnetic control coil of the present application has a higher magnetic field utilization efficiency compared to process of the prior art that circular coils or saddle-shaped coils are densely wound layer by layer using single superconducting wire material with a rectangular cross-section.

The advantages of the magnetic control coil of the present application will be further explained below in combination with traditional magnetic control coils and winding processes. In the prior art circular or saddle-shaped magnetic control coils are formed by winding with rectangular cross-sections, during use of such magnetic control coils, as the coils continuously thicken in the radial direction, according to the Biot-Savart law, the efficiency of magnetic field generation decreases as the radial thickness of the coils increases, and more magnetic flux concentrates within the coils, resulting in higher magnetic fields inside the coils. Such coils often have difficulty in generating larger external magnetic fields to meet the demands of high magnetic field scenarios in industries such as crystal manufacturing. Furthermore, the higher magnetic field inside this type of coil will further weaken the current-carrying capacity of the conductive wires constituting the coil, reducing the utilization efficiency of the conductive wires. Meanwhile, due to the magnetic force being concentrated on the coil, the coil itself is subjected to influence of significant magnetic force, which adversely impacts coil fixation and the structural stability of the internal conductive wire arrangement. With the development of superconducting technology in recent years, these disadvantages of magnetic control coils have become even more pronounced in superconducting magnetic coils.

The magnetic control coil in the present application adopts a two-dimensional planar winding arrangement along the surface of the support structure, wherein the radial thickness of the coil corresponds to the number of layers of conductive wire/conductive wire groups. Specifically, the thickness may be that of one or two layers of conductive wire/conductive wire groups. The thickness of the coil in the radial direction is significantly reduced, which effectively prevents the concentration of magnetic flux within the coil interior, thereby reducing the influence of magnetic flux on the coil conductive wire, improving magnetic field utilization efficiency, and facilitating the generation of external magnetic fields with a higher intensity.

In some optional embodiments, conductive wires of the magnetic control coil of the present application consists of multiple groups of conductive wires. For example, in some scenarios, 19 conductive wires can be used to constitute the coil cable in the present application, with each conductive wire having a diameter of 0.6 mm.

In some embodiments, the coil support structure is arranged around the central axis; the i-th pair of coil assemblies among the N pairs of coil assemblies are symmetrically distributed relative to the central axis; and i is an integer not less than 1 and not greater than N.

Specifically, the coil support structure may be of integral construction or segmented construction, with no limitation imposed herein. The coil support structure of integral construction may be cylindrical in form; the coil support structure of segmented construction may be partial arc segments obtained by sectioning any two non-parallel planes that are parallel to the central axis of the cylindrical body. That is to say, the cross-section of the coil support structure may be an arc segment or annular in configuration. The coil support structure is arranged around the central axis, which may involve the surface of the coil support structure being uniformly distributed around the central axis. Based on the arrangement of the coil support structure, the i-th pair of coils are symmetrically distributed with respect to the central axis, thereby generating a transverse magnetic field perpendicular to the central axis from the symmetrically distributed i-th pair of coils, wherein i may take values of 1, 2, 3, etc., with no limitation imposed herein.

In some embodiments, the coil support structure is cylindrical, manufactured from stainless steel or aluminum alloy. The cylindrical configuration may be circular cylindrical or polygonal cylindrical. Furthermore, the cross-section of the polygonal cylindrical configuration may be polygonal, including quadrilateral, pentagonal, hexagonal, etc., without limitation herein.

The surface of the coil support structure may be provided with a thermal conductive layer having a high thermal conductivity coefficient. For example, the thermal conductive layer may comprise at least one of pure copper plate, pure aluminum plate, or piping through which cryogenic fluid flows, for enhancing thermal conduction.

In some embodiments, the cylindrical side surface of the coil support structure comprises coil regions and non-coil regions; the coil regions are used for winding and arranging coil assemblies, and the non-coil regions are configured as perforated structures. Specifically, the non-coil regions may be located at gap positions between two adjacent coil regions or may be positioned at the center of a particular coil assembly, without limitation herein. This arrangement can further reduce the weight and volume of the coil support structure through the provision of perforated structures, which has significant importance in certain superconducting magnetic control coils. For example, in the ultra-low temperature environment required for superconducting wire operation, when the weight and volume of the coil support structure are reduced, the cooling rate of the coils can thus be effectively improved, thereby enhancing the operational efficiency of the equipment.

In some embodiments, each coil assembly comprises M layers of coils, where M is an integer not less than 1; when M is not less than 2, the (j+1)-th layer coil is positioned above the surface of the j-th layer coil that is distal from the central axis, wherein j is an integer not less than 1 and not greater than M.

Referring to Figure 2, the number of layers M of the coil assembly can be set according to the required magnetic field strength, for example, M can be 1, 2, 3, etc. The selection of the number of layers is related to the number and the thickness of conductive wires used for winding the coils. In specific implementation processes, optimal magnetic control coil parameters can be obtained through limited experimentation of actual conditions. Specifically in the optimal embodiment of the present application, when the conductive wire is a superconducting wire, the conductive wire group consists of 19 conductive wires, and a single conductive wire is 0.6 mm, then optimally 2 layers of coils are used to constitute the magnetic control coil of the optimal embodiment of the present application.

In cases where M is not less than 2, the (j+1)-th layer coil and the i-th layer coil exhibit upper and lower two-layer two-dimensional planar distribution, where j may assume values of 1, 2, 3, etc., without limitation herein. The coil assemblies corresponding to different layers may be coils having identical winding patterns. Specifically, when the j-th layer coil is configured as a planar rectangular winding, the (j+1)-th layer coil may be wound above the j-th layer coil according to identical winding manner, thereby establishing two coil layers with identical planar structures in a direction perpendicular to the coil central axis. This dual-layer magnetic control coil configuration exhibits enhanced magnetic field generation capacity.

In some embodiments, the planar shape of each of the coil assemblies, when spread along the surface of the coil support structure, is in the form of concentric rectangle; and the concentric rectangle comprises first direction segments, wherein the first direction segments are line segments parallel to the direction of the central axis.

Wherein the surface of the support structure may be either planar or curved. For example, when the support structure has a polygonal cylindrical configuration, the lateral surfaces are planar, and in such cases a coil assembly may be positioned correspondingly on a single support structure surface, or alternatively may be positioned across multiple adjacent and continuous support structure surfaces, with no limitation imposed herein. When the support structure has a cylindrical configuration, the support structure surface exhibits a curved geometry.

When the coil assembly is spread along the surface of the coil support structure, the coil assembly exhibits a concentric rectangular planar configuration. Specifically, the concentric rectangular configuration comprises first direction segments, wherein the first direction segments are segments oriented parallel to the central axis direction.

In some embodiments, the concentric rectangle comprises second direction segments; and the second direction segments are line segments perpendicular to the direction of the central axis.

In some embodiments, to reduce degradation of insulation and conductive performance caused by excessive bending of the coil conductor, transition arcs or spline curves are disposed between adjacent first direction segments and second direction segments in the coil assembly, wherein the minimum curvature radius of the transition arcs or spline curves is not less than a preset threshold. Wherein, the preset threshold may be determined according to the overall dimensions of the coils in the actual coil assembly. When this minimum curvature radius of the transition curve exceeds the preset threshold, excessive bending strain of the superconducting wire material will cause degradation of current-carrying capacity, potentially affecting the magnetic field generation of the magnetic control coil.

In some embodiments, N pairs of coil assemblies are wound from a same group of conductive wires; and the same group of conductive wires are formed by multiple conductive wires through parallel winding, twisting, or braiding. The same group of conductive wires being formed by multiple conductive wires through parallel winding, twisting, or braiding can effectively improve engineering current density while being more conducive to implementing magnet manufacturing processes with precise wiring by making slots and embedding wires therein.

In some embodiments, the coil assembly is made of superconducting material, such as NbTi, Nb₃Sn, Mg₂B superconducting wire. When the coil in the present application is a superconducting coil, the magnetic control coil of the present application can generate stronger magnetic flux, thereby meeting the demand for high-strength transverse magnetic fields in the crystal manufacturing industry.

In some embodiments, the magnetic control coil has current leads, wherein the current leads are configured to connect the magnetic control coil with a power supply. That is to say, the coils in the N pairs of coil assemblies share the same current lead, with current being fed in from one end of the conductive wire and flowing out from the other end of the conductive wire, forming a closed loop of the magnetic control coil by connecting with the power supply, whereby the electric current in the coil causes the coil to generate magnetic field effects.

In some embodiments, grooves are provided on the surface of the coil support structure, wherein the grooves are configured to secure the coil assembly. The grooves may be configured according to the arrangement pattern of the coil assembly. For example, when the magnetic control coil requires winding along concentric rectangular paths, rectangular grooves may be machined in the coil support structure according to the concentric rectangular arrangement of the coil assemblies in the magnetic control coil during processing the coil support structure, and the conductive wires in the magnetic control coil are subsequently arranged in the grooves according to the groove configuration, thereby forming the magnetic control coil. Preferably, grooves corresponding to the first direction segments and second direction segments are machined exclusively on the surface of the coil support structure, such that the coil assembly is arranged in a planar configuration on the coil support structure surface according to the first direction segments and second direction segments, while transition arcs are naturally formed between adjacent first direction segments and second direction segments in the coil assembly based on the positioning function of the grooves. That is to say, no groove needs to be machined at the position corresponding to the transition arc of the coil assembly. It should be understood that the depth of the groove can be determined according to the number of coil assembly layers of the magnetic control coil that need to be arranged. For example, when two layers of coil assemblies need to be arranged, the depth can be determined according to the diameter of the conductive wire in the coil assembly. It should also be understood that fixing the coil assembly of the magnetic control coil by means of grooves is merely one method provided by the present application, in addition to which, there are various other methods that can be implemented, for example, using ultrasonic-assisted bonding or photocurable resin rapid bonding methods to perform the arrangement and forming of the coil assembly of the magnetic control coil, which the present application does not limit.

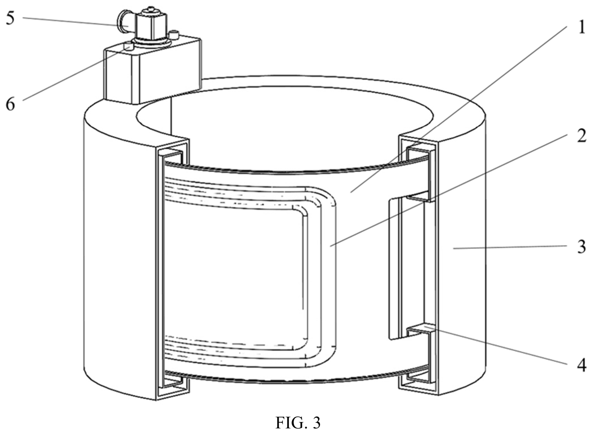

Figure 3 illustrates a crystal manufacturing equipment according to the present application, wherein the crystal manufacturing equipment can be utilized for silicon crystal manufacturing.

In some embodiments, the crystal manufacturing equipment comprises a crystal growth furnace and any of the aforementioned magnetic control coils; wherein the crystal growth furnace is configured with a heating device and a crucible for containing crystal raw materials, and the crucible is positioned within the chamber of the crystal growth furnace; the magnetic control coil is disposed around the crystal growth furnace and symmetrically distributed along the central axis of the crystal growth furnace.

On both sides of the crystal manufacturing equipment, the aforementioned coil assemblies may be symmetrically arranged, with the coil assemblies being distributed in a planar configuration along the surface of the coil support structure. Referring to Figure 3, the magnetic control coil comprises a coil support structure 1 and coil assemblies 2. The coil support structure 1 has a cylindrical configuration, and the coil assemblies 2 are positioned on both sides of the crystal manufacturing equipment. Specifically, the coil assemblies 2 can exist in pairs, for example, it can be 1 pair, 2 pairs, etc., which is not limited herein.

As shown in Figure 3, in some embodiments, the crystal manufacturing equipment of the present application further comprises a thermally insulated vacuum chamber 3, wherein the magnetic control coil is disposed within the interior of the thermally insulated vacuum chamber 3, to ensure that the magnetic control coil operates within an appropriate temperature range. For example, when the magnetic control coil is made from superconducting wire material, it often needs to operate at extremely low temperatures, and the thermally insulated vacuum chamber 3 can provide an effective working space for ultra-low temperature environments. In some optional embodiments, the thermally insulated vacuum chamber 3 can be configured as a hollow cavity, and liquid inert gas (such as liquid helium) can be injected into the cavity to ensure extremely low temperatures within the chamber, thereby providing an ultra-low temperature environment for the operation of superconducting coils. In some scenarios, this type of container having an isolated space as insulation chamber can be referred to as a Dewar container, within which a crystal growth furnace is disposed to perform crystal pulling.

The inner wall of the thermally insulated vacuum chamber of the present application can be the same component as the furnace wall of the crystal growth furnace (not shown), so as to further reduce the complexity of the crystal manufacturing equipment and save manufacturing costs. Certainly, in some embodiments, the thermally insulated vacuum chamber and the magnetic control coil may be mutually independent separate components, with the inner wall of the thermally insulated vacuum chamber maintaining a certain spacing from the crystal growth furnace wall. In some optional embodiments, the coil support structure 1 may be configured as a perforated structure, that is, support structures are provided in the coil regions while perforated structures may be provided in the non-coil regions, which can substantially reduce the mass of the support structure while simultaneously reducing the cooling load in low-temperature environments, thereby improving cooling efficiency.

In crystal preparation apparatus, crystals grown by the Czochralski method are often highly susceptible to the influence of melt thermal convection, thereby affecting crystal quality, introducing impurities, or causing various defects to occur at the solid-liquid interface of the crystal. By symmetrically positioning magnetic control devices around the crystal growth furnace, the transverse magnetic field generated by the magnetic control devices can effectively suppress the influence of thermal convection on the solid-liquid interface during crystal growth processes, thereby obtaining crystals of high quality. The magnetic control coil provided in the present application can generate stronger transverse magnetic fields, exhibiting superior suppression effects on thermal convection during the preparation of large-size monocrystalline silicon. It should be understood that the magnetic control coil shown in Figure 3 of the present application is merely a simple exemplary embodiment, and may be in various forms in actual use, which is not limited herein.

In one embodiment, the interior of the thermally insulated vacuum chamber 3 where the magnetic control coil is located is a vacuum environment, and the magnetic control coil is suspended in the vacuum environment of the thermally insulated vacuum chamber 3 by suspension rods. The suspension rods may be made of materials with high strength and poor thermal conductivity.

In some embodiments, the crystal manufacturing equipment proposed in the present application further comprises: a refrigeration apparatus, wherein the refrigeration apparatus is configured to reduce the temperature inside the thermally insulated vacuum chamber 3. The refrigeration apparatus 4 may include a radiation cold shield 4 and a refrigerator 5, wherein the radiation cold shield 4 completely encloses the magnetic control coil, and a certain gap may be provided between the inner wall of the radiation cold shield 4 and the magnetic control coil to avoid solid heat conduction, and multiple layers of aluminum-plated film are wrapped on the surface. The radiation cold shield is maintained within a temperature range of 60 K to 100 K through the first-stage cold head of the refrigerator 5, thereby blocking thermal radiation from the outer wall of the thermally insulated vacuum chamber 3 at room temperature, ensuring a low-temperature operating environment for the internal magnetic control coil assembly. For example, when the coil assemblies 2 in the magnetic control coil are a superconducting coil, the ultra-low temperature of the magnetic control coil component can be maintained through liquid inert gas and refrigeration apparatus, thereby providing suitable operating temperature for the superconducting coil.

The crystal manufacturing equipment of the present application is described in detail below. Referring to Figure 3, a crystal manufacturing equipment comprises a coil support structure 1, coil assemblies 2, a thermally insulated vacuum chamber 3, a radiation cold shield 4, a refrigerator 5 and current leads 6, etc.

The coil support structure 1 and coil assemblies 2 together constitute the magnetic control coil, and in this embodiment the magnetic control coils are distributed in pairs on the surface of the coil support structure, it should be understood that on the back side of the visible side in the Figure 3 view, another coil assembly is provided, and these two coil assemblies can be wound by the same set of superconducting wire, and when the superconducting wire is in working state, the magnetic control coil formed by the symmetrically arranged coil assemblies generates a strong transverse magnetic field, and this transverse magnetic field can be applied to the molten raw materials inside the container, thereby suppressing the materials' thermal convection effect, making the crystal growth environment more stable, which is beneficial for obtaining high-quality crystal materials.

In this embodiment, to efficiently generate a horizontal transverse magnetic field, each turn of coil contained within each coil assemblies 2 typically exhibits a concentric rectangular shape with rounded corners when unfolded in a plane. The exterior of coil assemblies 2 can be provided with pre-tensioning force by aluminum alloy wire or brass wire to control potential displacement of coil assemblies 2 when subjected to electromagnetic forces. Process by low-temperature resistant insulating material is employed between coil support structure 1 and coil assemblies 2 and the external pre-tensioning structure. For example, polyimide or similar materials are utilized for insulation process to ensure that discharge breakdown does not occur during magnetic control operation or if being subjected to quench events. In some alternative embodiments, the coil support structure 1 can be manufactured with loop-shaped grooves through machining, 3D printing, or injection molding processes. These loop-shaped grooves can accommodate superconducting magnetic control coils, and the rectangular grooves can be embedded by two layers of coil assemblies, securing the magnetic control coils through the groove configuration. In other alternative embodiments, low-temperature resistant resin can also be used to fix the magnetic control coils on the surface of the coil support structure 1, ensuring that the magnetic control coils are arranged in a two-dimensional planar distribution. It should be understood that on the surface of a coil support structure having multiple coil assemblies, combinations based on the aforementioned different fixing methods can be implemented, for example, one coil assembly employs the loop-shaped groove method, while another coil assembly employs the ultra-low temperature resin method.

The thermally insulated vacuum chamber 3 has a cylindrical configuration, wherein the chamber formed by the cylindrical inner walls can accommodate the crystal growth furnace crucible. The crucible inside the crystal growth furnace contains crystal raw materials, and heating elements and insulation materials are disposed around the crucible to heat and melt the crystal raw materials within the crucible. In this embodiment, the thermally insulated vacuum chamber 3 can simultaneously function as the furnace wall of the crystal growth furnace. In some applications, this sealed furnace wall construction may be referred to as a vacuum outer Dewar vessel, wherein the enclosed space within the vessel can be maintained in a vacuum state through evacuation, thereby providing enhanced thermal isolation from the external environment to protect the internal components and provide an appropriately controlled temperature environment for the operation of the internal components.

The radiation cold shield 4 is installed in the thermally insulated vacuum chamber 3, completely covering the internal magnetic control coil assembly and maintaining a certain gap with both the inner wall of the external thermally insulated vacuum chamber and the outer surface of the internal magnetic control coil to prevent solid heat transfer. The magnetic control coil comprising coil support structure 1 and coil assembly 2, together with the radiation cold shield 4, are suspended within the thermally insulated vacuum chamber 3 by means of suspension rods or support components fabricated from high-strength, low thermal conductivity materials, thereby establishing a first temperature zone between the radiation cold shield 4 and the magnetic control coil, and a second temperature zone between the radiation cold shield 4 and the wall of the thermally insulated vacuum chamber 3. The first temperature zone and the second temperature zone are relatively independent, and during actual operation, they cooperate in coordination with the refrigeration apparatus, thus the temperature of the second temperature zone can be maintained at 60-100 K, while the temperature of the first temperature zone can be maintained below 10 K, thereby providing an appropriate temperature environment for the operation of the superconducting coil. The radiation cold shield 4 can be made of high thermal conductivity materials, with no specific limitations. The refrigerator 5 is disposed on the outer wall of the thermally insulated vacuum chamber 3 and is used for conductive cooling and temperature reduction of the magnetic control coil and the radiation cold shield 4. Cooling capacity, or cooling quantity, is transmitted inward by the cold head of the refrigerator through the cooling conduction structure within the thermally insulated vacuum chamber 3. The number of refrigerators 5 can be 1 unit, 2 units, 3 units, etc., which can be specifically configured according to requirements.

The current leads 6 are used to connect the magnetic control coil with the power supply, with current being delivered through the current lead to the magnetic control coil to charge it and generate a magnetic field. The current lead exhibits characteristics of high current-carrying capacity and low thermal load, enabling delivery of large current from the room temperature end into the extremely low temperature coil. When the current reaches the predetermined value, it remains stable and constant, and the magnetic field generated by the magnetic control coil achieves stable field strength and uniformity.

Although embodiments of the present application have been shown and described above, it is to be understood that the foregoing embodiments are exemplary and should not be construed as limiting the present application. Those of ordinary skill in the art may make changes, modifications, substitutions, and variations to the foregoing embodiments within the scope of the present application.

### Reference Numerals

- 1: Coil support structure
- 2: Coil assemblies
- 3: Thermally insulated vacuum chamber
- 4: Radiation cold shield
- 5: Refrigerator
- 6: Current lead

## Claims

1. A magnetic control coil, comprising: a coil support structure and N pairs of coil assemblies, wherein the coil assemblies are arranged in a planar manner along a surface of the coil support structure; and N is an integer not less than 1.

2. The magnetic control coil of claim 1, wherein the coil support structure is arranged around a central axis; an i-th pair of coil assemblies among the N pairs of coil assemblies are symmetrically distributed relative to the central axis; and i is an integer not less than 1 and not greater than N.

3. The magnetic control coil of claim 2, wherein the coil support structure is configured to be cylindrical and manufactured from stainless steel or aluminum alloy.

4. The magnetic control coil of claim 3, wherein a cylindrical side surface of the coil support structure comprises coil regions and non-coil regions;
and the coil region is configured to arrange the coil assemblies, and the non-coil region is configured as a perforated structure.

5. The magnetic control coil of claim 2, wherein each of the coil assemblies comprises M layers of coils, wherein M is an integer not less than 1; and in a case where M is not less than 2, a (j+1)-th layer coil is positioned above the surface of the j-th layer coil that is distal from the central axis, and j is an integer not less than 1 and not greater than M.

6. The magnetic control coil of claim 5, wherein a planar shape of each of the coil assemblies, when spread along the surface of the coil support structure, is in the form of concentric rectangle; the concentric rectangle comprises first direction segments, wherein the first direction segments are line segments parallel to the direction of the central axis.

7. The magnetic control coil of claim 6, wherein the concentric rectangle comprises second direction segments; and the second direction segments are line segments perpendicular to the direction of the central axis.

8. The magnetic control coil of claim 7, wherein transition arcs are disposed between the first direction segments and the second direction segments, and curvature radius of the arcs is not less than a preset threshold.

9. The magnetic control coil of claim 8, wherein the N pairs of coil assemblies are formed by winding a same group of conductive wires; the same group of conductive wires are formed by multiple conductive wires being arranged side by side, twisted, or braided together.

10. The magnetic control coil of claim 9, wherein the coil assembly is configured to be made of superconducting material.

11. The magnetic control coil of claim 1, wherein the magnetic control coil has current leads, and the current leads are configured to connect the magnetic control coil with a power supply.

12. The magnetic control coil of claim 4, wherein grooves are provided on the surface of the coil support structure, and the grooves are configured to secure the coil assembly.

13. The magnetic control coil of claim 1, wherein a thermal conductive layer is disposed on the surface of the coil support structure; and the thermal conductive layer comprises at least one of the following: a pure copper plate, a pure aluminum plate, or piping through which cryogenic fluid flows.

14. A crystal manufacturing equipment, comprising: a crystal growth furnace and the magnetic control coil of any one of claims 1 to 12; wherein the crystal growth furnace is configured with a heating device and a crucible for containing crystal raw materials, wherein the crucible is positioned within a chamber of the crystal growth furnace; and the magnetic control coil is positioned around the crystal growth furnace and symmetrically distributed along the central axis of the crystal growth furnace.

15. The crystal manufacturing equipment of claim 14, wherein the crystal manufacturing equipment further comprises: a thermally insulated vacuum chamber, within which the magnetic control coil is arranged.

16. The crystal manufacturing equipment of claim 15, wherein the crystal manufacturing equipment further comprises: a refrigeration apparatus, which is configured to reduce the temperature within the thermally insulated vacuum chamber.

17. The crystal manufacturing equipment of claim 16, wherein interior of the thermally insulated vacuum chamber provides a vacuum environment, and the magnetic control coil is suspended within the vacuum environment of the thermally insulated vacuum chamber by means of a suspension rod.
